# EUROPÄISCHE PATENTSCHRIFT

(11) **EP 1 686 708 B1**
(45) Veröffentlichungstag und Bekanntmachung des Hinweises auf die Patenterteilung: **12.11.2008**
(21) Anmeldenummer: 05090021.6
(22) Anmeldetag: 26.01.2005
(51) Int. Cl.: H04B 10/155, H04B 10/00, H01S 5/40

(54) **Verfahren und Vorrichtung zum Betreiben einer optischen Sendevorrichtung, die eine Mehrzahl von unabhängig ansteuerbaren optischen Sendern aufweist**
Method of operating an optical transmitter comprising a multitude of independently controllable optical transmitters, and respective device.
Procédé d'opération d'un émetteur optique comportant une multitude d'émetteurs optiques controlables indépendement, et émetteur correspondant

(43) Veröffentlichungstag der Anmeldung: 02.08.2006
(73) Patentinhaber: Avago Technologies Fiber IP (Singapore) Pte. Ltd., Singapore 768923 (SG)
(72) Erfinder: Lichtenegger, Thomas, 93087 Alteglofsheim (DE); Hurt, Hans, 93049 Regensburg (DE); Steinle, Gunther, 81543 München (DE); Schrödinger, Karl, 14089 Berlin (DE); Wittl, Josef, 92331 Parsberg (DE); Prucker, Stephan, 93133 Burgenlengenfeld (DE); Müller, Gustav, 94482 Osterhofen (DE); Pfeiffer, Joachim, 83620 Feldkirchen (DE)
(74) Vertreter: Dilg, Haeusler, Schindelmann Patentanwaltsgesellschaft mbH

(56) Entgegenhaltungen:
- EP-A- 1 324 521
- US-A- 4 403 139
- US-A- 4 696 060

## Beschreibung

Bezeichnung der Erfindung: Verfahren und Vorrichtung zum Betreiben einer optischen Sendevorrichtung, die eine Mehrzahl von unabhängig ansteuerbaren optischen Sendern aufweist.

Die Erfindung betrifft ein Verfahren und eine Vorrichtung zum Betreiben einer optischen Sendevorrichtung, die eine Mehrzahl von unabhängig ansteuerbaren optischen Sendern aufweist. Insbesondere betrifft die Erfindung eine intelligente Auswahl eines der Sender einer solchen optischen Sendevorrichtung für einen Kommunikationsbetrieb.

Es sind monolithische optoelektronische Chips bekannt, auf denen eine Mehrzahl unabhängig voneinander ansteuerbarer Laserdioden realisiert sind. Von der Mehrzahl der Laserdioden dient zu einem betrachteten Zeitpunkt eine der Laserdioden einer Datenkommunikation, während die anderen als redundante Laserdioden für den Fall vorgehalten werden, dass die aktuell verwendete Laserdiode ausfällt oder vorgegebene Qualitätskriterien insbesondere hinsichtlich der Lichtleistung unterschreitet. So liegt die Ausfallrate von Laserdioden, abhängig von der Betriebstemperatur, bei 50 bis 200 ppm. Durch die Verwendung redundanten Sendequellen kann die Ausfallrate einer Sendevorrichtung auf weniger als 10 ppm reduziert werden.

Sofern die aktuell verwendete Laserdiode ausfällt oder vorgegebene Qualitätskriterien unterschreitet, wird auf eine andere der Laserdioden gewechselt und diese zur Datenkommunikation verwendet. Die Sequenz der verwendeten Laserdioden ist dabei fest vorgegeben. Dabei besteht die Gefahr, dass die Ersatz-Laserdiode vorgebene Qualitätskriterien ebenfalls unterschreitet.

Des weiteren ist bekannt, sämtliche Laserdioden eines Chips mit mehreren Laserdioden gleichzeitig zur Datenkommunikation zu verwenden, wobei von den Laserdioden dasselbe Signal ausgesandt wird. Bei einem Ausfall einer der Laserdioden erfolgt die weitere Datenkommunikation mit den verbleibenden Laserdioden. Diese Lösung weist allerdings den Nachteil auf, dass der Laserbetrieb mit einem hohen Stromverbrauch und einer hohen Temperatur erfolgt.

Aus der Druckschrift US 4 403 139 ist eine Schaltung zum Betreiben einer Lichtquelle (z.B. einer LED oder eines Lasers) bekannt, die die Lichtleistung der Lichtquelle überwacht und für den Fall, dass die Lichtleistung unter einen bestimmten Minimalwert fällt, eine Ersatzlichtquelle aktiviert.

Zudem ist aus dem Dokument US 4 696 060 eine Anordnung von Sendern (Lasern) bekannt, in der einer Mehrzahl aktiver Sender jeweils ein redundanter Sender zugeordnet ist. Fällt ein aktiver Sender aus, wird der ihm zugeordnete redundante Sender aktiviert.

Der vorliegenden Erfindung liegt die Aufgabe zu Grunde, ein Verfahren und eine Vorrichtung zum Betreiben einer optischen Sendevorrichtung mit einer Mehrzahl von unabhängig ansteuerbaren optischen Sendern zur Verfügung zustellen, die sich durch eine intelligente Auswahl des aktuell verwendeten Senders auszeichnen.

Diese Aufgabe wird erfindungsgemäß durch ein Verfahren mit den Merkmalen des Anspruchs 1 und eine Vorrichtung mit den Merkmalen des Anspruchs 15 gelöst. Bevorzugte und vorteilhafte Ausgestaltungen der Erfindung sind in den Unteransprüchen angegeben.

Danach zeichnet sich das erfindungsgemäße Verfahren dadurch aus, dass zunächst zu mindestens einem Parameter die Parameterwerte der einzelnen Sender erfasst werden. Die ermittelten Parameterwerte werden miteinander und/oder mit einem vorgegebenen Vergleichswert verglichen. Beispielsweise werden die Lichtleistungen der einzelnen Lichtsender der Sendevorrichtung miteinander oder mit einem vorgegebenen optimalen Lichtleistungswert verglichen. Anschließend wird einer der Sender für den Kommunikationsbetrieb der Sendevorrichtung ausgewählt, und zwar anhand des durchgeführten Vergleichs. Beispielsweise wird der Lichtsender mit der höchsten Lichtleistung für den Kommunikationsbetrieb ausgewählt. Es wird dann die Sendevorrichtung allein mit dem ausgewählten Sender betrieben, während die anderen Sender als redundante Sender vorgehalten werden.

Es wird darauf hingewiesen, dass der Verfahrensschritt des Betreibens nicht zeitlich unmittelbar an den Verfahrensschritt des Auswählens anschließen muss, diese zeitlich vielmehr auseinander liegen können.

Es ist bevorzugt vorgesehen, dass die erfassten Parameterwerte oder davon abgeleiteter Werte in einem Speicher gespeichert werden. Bei Abweichen des aktuell für den Kommunikationsbetrieb verwendeten Senders von einem vorgegebenen Kriterium (z.B. ob die Lichtleistung des Senders unter einen vorgegenbenen Mindestwert wert) wird ein Ersatzsender aus der Mehrzahl der Sender anhand der gespeicherten Werte ausgewählt und für den weiteren Kommunikationsbetrieb verwendet. Dies ermöglicht es, bei Ausfall des aktuellen Senders nicht einen beliebigen anderen Lichtsender zu verwenden, dessen Parameterwerte möglicherweise nur mittelmäßig oder schlecht sind, sondern denjenigen Lichtsender auszuwählen, der bestimmte Kriterien nun am besten erfüllt, beispielsweise die höchste Lichtleistung aufweist. Dies ist derjenige Sender, der bei der Messung die vorgegebenen Kriterien am zweitbesten erfüllte. Bei einem weiteren Ausfall wird auf den nächstbesten Sender gewechselt, usw.

Unter einem "Ausfall eines Lichtsenders" wird dabei zum einen der Fall verstanden, dass ein Lichtsender in dem Sinne ausfällt, dass er kein Licht mehr emittiert, zum anderen aber auch der Fall, dass ein vorgegebenes Kriterium nicht mehr erfüllt wird.

Es wird darauf hingewiesen, dass unter einem Parameter ein Parameter einer Laserdiode verstanden wird, beispielsweise die Lichtleistung oder die Betriebstemperatur. Ein Parameterwert ist der Wert des Parameters bei einer zu einem bestimmten Zeitpunkt durchgeführten Messung. Unter einem Parameterwert wird allerdings auch ein von dem eigentlichen Parameterwert abgeleiteter Wert verstanden, der in einer definierten Beziehung zum dem gemessenen Parameterwert steht. Ein solcher abgeleiteter Wert ist beispielsweise der Strom einer Monitordiode, die einen bestimmten Teil des durch den Lichtsender emittierten Lichts detektiert, während die Lichtleistung der eigentlich Parameterwert ist. Der Strom der Monitordiode representiert die Lichtleistung, weswegen er ebenfalls als Parameterwert im Sinne der Erfindung angesehen wird. Insbesondere spielt es keine Rolle, ob die eigentlichen Parameterwerte oder davon abgeleitete Werte miteinander verglichen und in dem Speicher gespeichert werden. Abgeleitete Werte können auch eine Reihenfolge sein, in der die Sender zu betreiben sind.

In der Erfindung ist vorgesehen, dass ein Wechsel des für den Kommuniktionsbetrieb verwendeten Senders dadurch erfolgt, dass der bisher verwendete Sender in seiner Lichtleitung reduziert und gleichzeitig der neu ausgewählte Sender in seiner Lichtleistung erhöht wird, wobei während einer Übergangszeit beide Sender Licht emittieren. Es liegt ein langsamer Wechsel vor, der verhindert, dass die bisherige Sendequelle abrupt umgeschaltet wird und beim Umschalten Daten verloren gehen.

In einer weiteren bevorzugten Ausgestaltung werden die Schritte des Erfassens, Vergleichens und Auswählens in einer Startphase der Sendevorrichtung durchgeführt. Besonders bevorzugt werden sie in jeder Startphase, also bei jedem Neustart durchgeführt, so dass stets die aktuellen Parameterwerte zur Verfügung stehen. Die in dem Speicher bisher gespeicherten Parameterwerte werden dabei durch die bei der erneuten Startphase aktuell erfassten Parameterwerte überschrieben.

Alternativ kann jedoch auch vorgesehen sein, dass die Schritte des Erfassens, Vergleichens und Auswählens am Ende der Fertigung der Sendevorrichtung durchgeführt werden (Endof-Line Test) und in einem nichtflüchtigen Speicher gespeichert wird, welcher der Sender initial für einen Kommunikationsbetrieb zu verwenden ist und in welcher Reihenfolge weitere der Sender als Ersatzsender bereitstehen. Die Reihenfolge, in der die Lichtsender zu verwenden sind, wird also durch einen Test am Ende der Fertigung festgelegt und nichtflüchtig gespeichert. Der entsprechende nichtflüchtige Speicher ist beispielsweise in die Sendevorrichtung integriert.

In einer Ausgestaltung der Erfindung werden die Sender zur Erfassung der Lichtleistung sequentiell angesteuert und erfasst ein Lichtdetektor einen Teil des emittierten Lichts des jeweils angesteuerten Senders. Dies ermöglicht es, zur Bestimmung der Parameterwerte aller Sender nur einen Lichtdetektor zu verwenden. Alternativ ist jedem Sender eine gesonderte Monitordiode zugeordnet, die die Lichtleistung jeweils eines Senders erfasst. Es kann dann eine parallele Erfassung der Lichtleistungen erfolgen.

Des weiteren ist bevorzugt vorgesehen, dass für einen Sender, bei dem der ermittelte Parameterwert mehr als einen vorgegebenen Toleranzwert von einem idealen Wert abweicht, ein Sperrflag gesetzt wird, das den entsprechenden Sender für einen Kommunikationsbetrieb sperrt.

Die erfindungsgemäße Vorrichtung zum Betreiben einer optischen Sendevorrichtung weist auf:
- einen Ausgangstreiber zum Ansteuern der optischen Sender unabhängig voneinander,
- einen Komparator, der Parameterwerte miteinander und/oder mit einem Referenzwert vergleicht, die zu mindestens einem Parameter der Sender von jedem Sender aktuell erfasst sind, und
- eine mit dem Komparator verbundenen Steuervorrichtung, die auf der Grundlage des durch den Komparator durchgeführten Vergleichs Steuerbefehle an den Ausgangstreiber gibt, einen bestimmten der Mehrzahl der Sender zu betreiben.

Bevorzugt ist die Steuervorrichtung mit einem Speicher verbunden, in dem die ermittelten Parameterwerte oder davon abgeleitete Werte gespeichert sind.

Die Erfindung wird nachfolgend unter Bezugnahme auf die Figuren an einem Ausführungsbeispiel näher erläutert. Es zeigen:
- Figur 1: eine Vorrichtung zum Betreiben einer optischen Sendevorrichtung mit mehreren optischen Sendern;
- Figur 2: die optische Leistung der Sendevorrichtung, die elektrische Energieversorgung der Sendevorrichtung und eine Datenübertragung der Sendevorrichtung, jeweils in Abhängigkeit von der Zeit; und
- Figur 3: die optische Leistung der Sendevorrichtung, den Strom durch einen ersten Sender der Sendevorrichtung und den Strom durch einen zweiten Sender der Sendediode, jeweils in Abhängigkeit von der Zeit, bei einem Wechsel des für die Datenübertragung verwendeten Senders "on the fly".

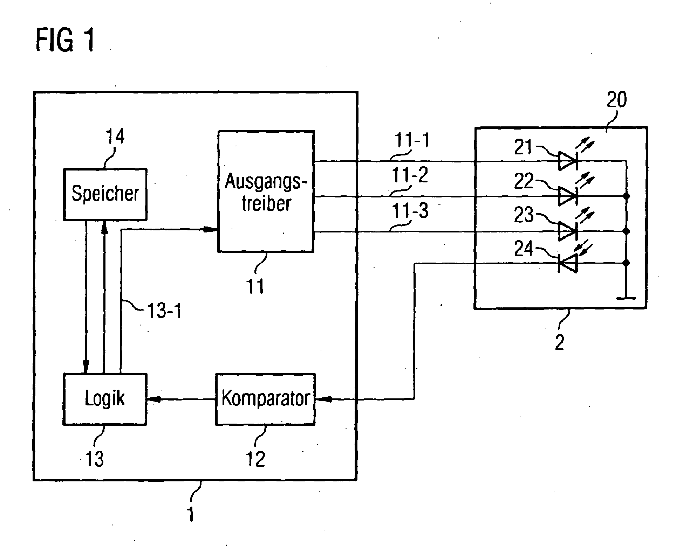

Die Figur 1 zeigt eine Vorrichtung bzw. eine Schaltungsanordnung 1 zum Betreiben einer optischen Sendevorrichtung 2. Die optische Sendevorrichtung 2 ist im dargestellten Ausführungsbeispiel, jedoch nicht notwendigerweise, als monolithischer Chip 20 ausgeführt, auf dem eine Mehrzahl, im dargestellten Ausführungsbeispiel drei VCSEL-Laserdioden 21, 22, 23 realisiert sind, die drei optische Ausgangskanäle der Sendevorrichtung 2 bereitstellen. Des Weiteren ist auf dem monolithischen Chip 20 eine Monitordiode 24 realisiert, die detektiertes Licht in Strom konvertiert.

Die Vorrichtung 1 zum Betreiben der Sendevorrichtung 2 weist einen Ausgangstreiber 11, einen Komparator 12, eine Steuerlogik 13 und einen Speicher 14 auf. Obwohl diese Komponenten in der Darstellung der Figur gesondert dargestellt sind, können sie durch eine Schaltung realisiert sein. Beispielsweise kann der Komparator 12 in die Steuervorrichtung 13 integriert sein, wobei beide beispielsweise durch Software implementiert sind, die von einem Mikroprozessor abgearbeitet wird. Im einfachsten Fall sind der Komparator 12 und die Steuervorrichtung 13 durch logische Bausteine bzw. Gatter realisiert, die in einen Treiberbaustein integriert sind.

Der Ausgangstreiber 11 dient der Ansteuerung der drei optischen Sender 21, 22, 23 der Sendevorrichtung 2. Der Ausgangstreiber 11 ist dabei derart ausgebildet, dass er die Laserdioden 21, 22, 23 individuell und selektiv ansteuern kann. Dies erfolgt über Ausgangs-Steuerkanäle 11-1, 11-2, 11-3.

Der Komparator 12 weist einen Eingang und einen Ausgang auf. Der Eingang ist mit der Monitordiode 24 der Sendevorrichtung 2 verbunden. Der Ausgang ist mit der Logiksteuerung 13 verbunden. Der Logiksteuerung 13 ist der Speicher 14 zugeordnet, in den die Logiksteuerung 13 Werte hineinschreiben und aus dem sie gespeicherte Werte herauslesen kann. Der Logikbaustein 13 ist des Weiteren über eine Steuerleitung 13-1 mit dem Ausgangstreiber 11 verbunden und kann diesem über die Steuerleitung 13-1 Steuersignale zur Ansteuerung der Laserdioden 21, 22, 23 übermitteln.

Der Speicher 14 ist beispielsweise als Flip-Flop oder als Flash-Speicher realisiert.

Die Funktionsweise der beschriebenen Anordnung ist wie folgt. Von den drei Laserdioden 21, 22, 23 soll eine für eine Datenkommunikation ausgewählt werden, während die anderen Laserdioden als redundante Laserdioden beim Ausfall der ausgewählten Laserdiode bereitstehen. Für eine intelligente Auswahl einer geeigneten Laserdiode für den Kommunikationsbetrieb wird in der Startphase des Systems zu sämtlichen vorhandenen Laserdioden 21, 22, 23 ein bestimmter Parameter bestimmt, der ein Ausfallkriterium darstellt. In dem dargestellten Ausführungsbeispiel wird als Parameter die Lichtleistung der Laserdioden bestimmt.

Ein anderer möglicher Parameter ist beispielsweise die Betriebstemperatur. Es werden dann geeignete Sensoren zur Erfassung der Betriebstemperatur in die Sendevorrichtung integriert. Ein möglicher Parameter ist des weiteren der Schwellenwert bzw. Schwellenstrom der Laserdioden, d.h. der Wert, bei dem sich ein Knick in der PI-Kennlinie ergibt.

Zur Bestimmung der Lichtleistung werden während der Startphase die Laserdioden 21, 22, 23 durch den Ausgangstreiber 11 sequenziell angesteuert. Die Fotodiode 24 detektiert bei der sequenziellen Ansteuerung zunächst das von der Laserdiode 21 emittierte Licht, dann das von Laserdiode 22 emittierte Licht, dann das von der Laserdiode 23 emittierte Licht. Die ermittelten Lichtleistungswerte bzw. zu diesen äquivalente Stromwerte der Monitordiode 24 werden im Komparator 12 miteinander verglichen und das Ergebnis des Vergleichs der Logiksteuerung 13 mitgeteilt. Zusätzlich werden die ermittelten Werte in dem Speicher 14 abgespeichert.

Zur Ermittlung der Lichtleistung der einzelnen Laserdioden 21, 22, 23 kann alternativ auch vorgesehen werden, dass nach Betreiben der ersten Laserdiode 21 die beiden anderen Laserdioden sequentiell zugeschaltet werden, so dass die Monitordiode 24 zunächst nur das Licht der Laserdiode 21, dann das Licht der Laserdioden 21, 22 und dann das Licht aller drei Laserdioden 21, 22, 23 detektiert. Hieraus kann dann auf die Lichtleistung der einzelnen Dioden zurück gerechnet werden, wobei hierzu allerdings erforderlich ist, dass die Monitordiode 24 in dem betrachteten Bereich streng linear arbeitet. Eine weitere Möglichkeit zum Erfassen der Lichtleistung der einzelnen Laserdioden 21, 22, 23 besteht darin, dass jeder Laserdiode eine eigene Monitordiode zugeordnet ist (nicht dargestellt).

Der Komparator 12 vergleicht, wie bereits erwähnt, die von der Monitordiode 24 erzeugten Ströme, die den jeweiligen Lichtleistungen der Fotodioden 21, 22, 23 entsprechen. Die einzelnen Ströme werden im Komparator 12 miteinander verglichen (entweder sequentiell oder auch parallel) und es wird von der Logiksteuerung diejenige Laserdiode ausgewählt, die die größte Lichtleistung bzw. Ausgangsleistung aufweist. Die Logiksteuerung 13 sendet dann über die Steuerleitung 13-1 einen Steuerbefehl an den Ausgangstreiber 11, die Laserdiode mit der höchsten Lichtleistung für den Kommunikationsbetrieb auszuwählen und entsprechend anzusteuern.

Gleichzeitig werden die ermittelten Stromwerte bzw. Lichtleistungswerte der einzelnen Laserdioden 21, 22, 23 in den Speicher 14 geschrieben.

Die Sendevorrichtung 2 wird nun zunächst mit allein der Laserdiode betrieben, die die höchste Ausgangsleistung besitzt. Über die Monitordiode 24, die einen Teil des emittierten Lichts detektiert, wird während des Betriebs fortlaufend die aktuelle Lichtleistung überwacht. Sofern die aktuelle Lichtleistung unter einen definierten, vorgegebenen Wert fällt, wird eine andere Laserdiode für den Kommunikationsbetrieb ausgewählt. Dies erfolgt, indem der Logikbaustein 13 die in dem Speicher 14 abgespeicherten Werte ausliest und feststellt, welche der Laserdioden den zweitbesten Lichtleistungswert besitzt. Diese Laserdiode wird dann für den weiteren Kommunikationsbetrieb verwendet.

Dabei kann vorgesehen sein, dass ein "langsamer" Wechsel auf die neue Sendequelle erfolgt, indem zu der bisher verwendeten Sendequelle die Lichtleistung in einer Übergangszeit reduziert und gleichzeitig dazu während der Übergangszeit die Lichtleistung der neuen Sendequelle bis auf einen maximalen Wert erhöht wird. Hierdurch wird sichergestellt, dass der Kommunikationsbetrieb während des Wechselns der verwendeten Laserdiode fehlerfrei funktioniert und die übertragene Information nicht gestört wird.

Ein weiterer Vorteil des beschriebenen Verfahrens besteht darin, dass die Wahrscheinlichkeit sehr gering ist, das ein Umschalten während des Betriebsmodus überhaupt erforderlich ist. So wird nach der Startphase und von vornherein die geeignetste der vorhandenen Laserdioden für den Kommunikationsbetrieb verwendet.

Des Weiteren vermeidet das beschriebene Auswahlverfahren, dass ein versehentliches Schalten auf einen bereits stark gealterten Kanal mit geringer Lichtleistung erfolgt, da die relative Stärke sämtlicher Laserdioden zu Beginn einer Betriebsphase gespeichert wird und gespeichert bleibt. Dies kann alternativ oder zusätzlich auch durch ein entsprechendes Speicherflag verhindert werden, das den stark gealterten Kanal sperrt.

Das beschriebene Auswahlverfahren verhindert auch, dass ein aufgrund ungünstiger Betriebsbedingungen während des Betriebs versehentlich für gealtert befundener Kanal auf Dauer gesperrt und für die Datenkommunikation nicht mehr verwendet wird. Denn bei jedem Neustart des Systems wird erneut das beschriebene Mess- und Auswahlverfahren durchgeführt, wobei die in dem Speicher 14 gespeicherten Werte mit den neu ermittelten Parameterwerten bzw. davon abgeleiteten Werten überschrieben werden. Ein versehentlich für gealtert befundener Kanal wird bei einem Neustart des Systems daher wieder unter vergleichbaren Bedingungen mit den anderen Kanälen verglichen und eine eventuelle frühere Fehleinschätzung dabei erkannt.

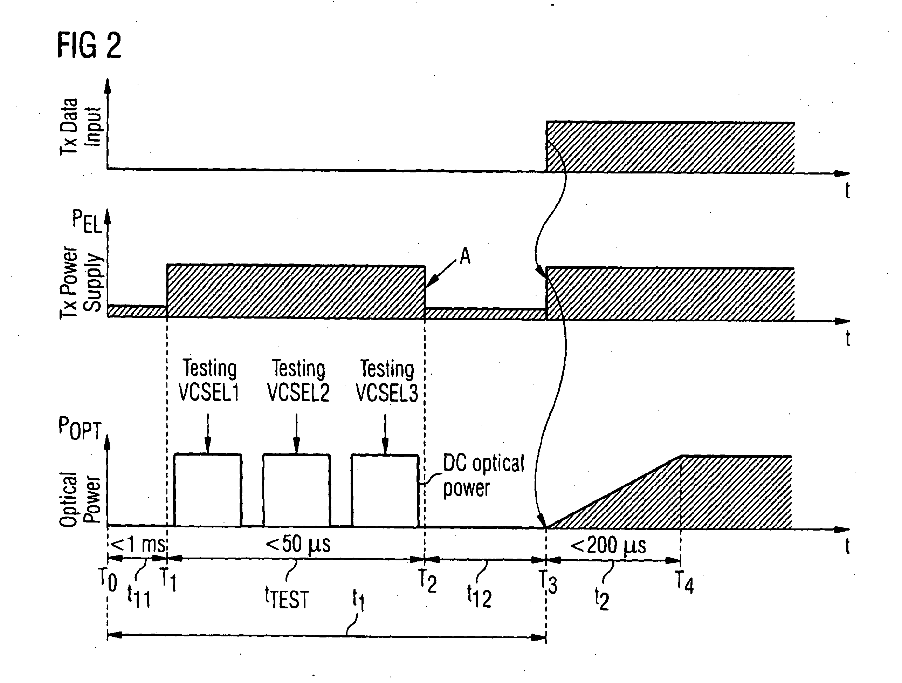

Die Figur 2 zeigt zur Erläuterung des beschriebenen Verfahrens in Abhängigkeit von der Zeit t die optische Leistung P_{OPT} der Sendevorrichtung 2, die Energieversorgung P_{EL}bzw. die Energiezufuhr der Sendevorrichtung 2 und das Anliegen von zu übertragenden Daten.

Eine Startphase ist durch das Zeitintervall t₁ gegeben. Diese Startphase t₁ gliedert sich in eine erste Phase t₁₁, in der sich das System z.B. im Schlaf-Modus befindet. Daran schließt sich beginnend mit dem Zeitpunkt T₁ eine Testphase tₜₑₛₜ an, der z.B. eine weitere Schlafphase t₁₂ folgt. Die Startphase endet nach Ablauf des Zeitintervalls t₁ zum Zeitpunkt T₃. Zum Zeitpunkt T₃ beginnt gemäß der oberen Kurve eine Datenübertragung. Während einer Zeit t₂ steigt die optische Leistung des verwendeten Senders dabei bis zu einem maximalen Wert an. Diese Ansteigzeit t₂ endet zum Zeitpunkt T₄. Zu Zeiten größer als T₄ findet eine normale Datenübertragung statt.

In der Testphase tₜₑₛₜ werden sequentiell die einzelnen Laserdioden 21, 22, 23 getestet bzw. mit Strom versorgt und dabei die optische Leistung gemessen. Zum Zeitpunkt T₂, d.h. am Ende der Testphase tₜₑₛₜ werden die erfassten optischen Leistungen miteinander verglichen und in dem Speicher 14 gespeichert. Es wird dann die Laserdiode für den Kommunikationsbetrieb ausgewählt, die die höchste Lichtleistung besitzt. Die Datenübertragung beginnt mit dem Zeitpunkt T₃, wobei ab dem Zeitpunkt T₄ eine normale Datenübertragung vorliegt.

Die Energieversorgung der Sendevorrichtung 2 ist gemäß der mittleren Kurve während der Testphase tₜₑₛₜ erhöht, da die Laserdioden in der Testphase sequentiell mit Strom versorgt werden. Wenn zum Zeitpunkt T₂ keine zu übertragenden Daten vorliegen, geht das System wieder in den Schlafmodus zurück (vgl. Pfeil A), bis nach Ablauf der Zeit t₁₂ eine Datenübertragung beginnt. Insofern kann auch die Zeit t₁₁ + tₜₑₛₜ als Startphase betrachtet werden.

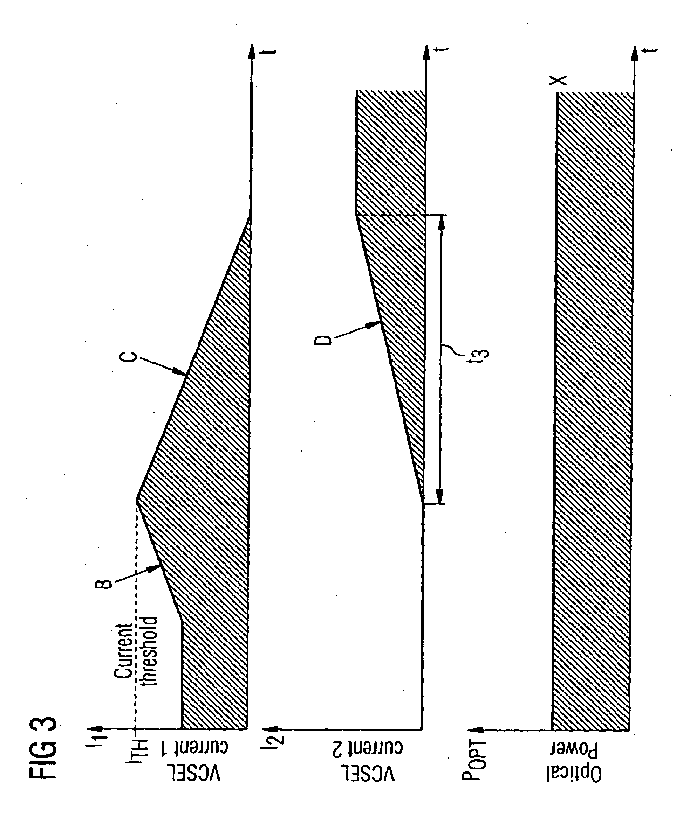

Die Figur 3 stellt das beschriebene Wechseln der verwendeten Laserdiode während einer Übergangszeit, "on the fly" dar. Gemäß der Ausgangssituation erfolgt eine Datenkommunikation mit einer entsprechend dem zuvor beschriebenen Verfahren ausgewählten ersten Laserdiode. Hierzu fließt ein erster Strom I₁ durch die ausgewählt Laserdiode. Mit zunehmendem Altern der Laserdiode ist es erforderlich, eine vorgegebene Lichtleistung mit einem zunehmend höheren Strom zu realisieren. Dementsprechend nimmt in dem Übergangsbereich D der Strom I₁ durch die Laserdiode zu. Wenn der erforderliche Strom einen Grenzwert I_{TH} erreicht, so erkennt die Steuerlogik 13 dies als Kriterium, diese Laserdiode aufgrund ihres Alters nicht weiter zu verwenden und stattdessen auf eine andere Laserdiode umzuschalten.

Das Umschalten erfolgt bevorzugt jedoch nicht abrupt, sondern während einer Übergangszeit t₃. Während dieser Übergangszeit t₃ wird der Strom durch die bisher verwendete Laserdiode in dem Bereich C stetig reduziert. Gleichzeitig wird der Strom I₂ durch eine entsprechend dem beschriebenen Verfahren ausgewählte Ersatz-Laserdiode in dem Bereich D stetig bis zu einem maximalen Wert am Ende der Übergangszeit t₃ erhöht. Die optische Leistung Pₒₚₜ weist dabei einen im wesentlichen konstanten Wert X auf und ist nicht mit Schwankungen oder Unterbrechungen verbunden. Es erfolgt ein sanfter Wechsel "on the fly".

Die Erfindung beschränkt sich in ihrer Ausgestaltung nicht auf das vorstehend dargestellte Ausführungsbeispiel. Beispielsweise kann eine andere Anzahl von redundanten Laserdioden vorgesehen sein. Auch können anstatt VCSL-Laserdioden andere Laserdioden oder beliebige andere Sendequellen verwendet werden.

## Patentansprüche

1. Verfahren zum Betreiben einer optischen Sendevorrichtung (2), die eine Mehrzahl von unabhängig ansteuerbaren optischen Sendern (21, 22, 23) aufweist, mit den Schritten:
- Erfassen zu mindestens einem Parameter die Parameterwerte der einzelnen Sender (21, 22, 23);
- Vergleichen der von jedem Sender ermittelten Parameterwerte miteinander und/oder mit einem vorgegebenen Vergleichswert,
- Auswählen eines der Sender (21, 22, 23) für den Kommunikationsbetrieb der Sendevorrichtung (1) anhand des Vergleichs,
- Betreiben der Sendevorrichtung (2) mit dem ausgewählten Sender, **dadurch gekennzeichnet, daß**
- bei Abweichen des aktuell für den Kommunikationsbetrieb verwendeten Senders von einem vorgegebenen Kriterium ein Ersatzsender aus der Mehrzahl der Sender (21, 22, 23) ausgewählt wird,
- ein Wechsel des für den Kommuniktionsbetrieb verwendeten Senders **dadurch** erfolgt, dass der bisher verwendete Sender in seiner Lichtleitung reduziert und gleichzeitig der Ersatzsender in seiner Lichtleistung erhöht wird, wobei während einer Übergangszeit beide Sender Licht emittieren.

2. Verfahren nach Anspruch 1, **gekennzeichnet durch** die weiteren Schritte:
- Speichern der erfassten Parameterwerte oder davon abgeleiteter Werte in einem Speicher (14),
- Auswahl des Ersatzsenders anhand der gespeicherten Werte, und
- Verwenden des neu ausgewählten Senders für den weiteren Kommunikationsbetrieb.

3. Verfahren nach mindestens einem der vorangehenden Ansprüche, **dadurch gekennzeichnet, dass** die Schritte des Erfassens, Vergleichens und Auswählens in einer Startphase der Sendevorrichtung (2) durchgeführt werden.

4. Verfahren nach Anspruch 3, **dadurch gekennzeichnet , dass** die Schritte des Erfassens, Vergleichens und Auswählens in jeder Startphase der Sendevorrichtung (2) durchgeführt werden.

5. Verfahren nach den Ansprüchen 2 und 4, **dadurch gekennzeichnet, dass** bei jeder Startphase die in dem Speicher (14) gespeicherten Parameterwerte durch die bei der Startphase aktuell neu erfassten Parameterwerte überschieben werden.

6. Verfahren nach mindestens einem der Ansprüche 1 oder 2, **dadurch gekennzeichnet, dass** die Schritte des Erfassens, Vergleichens und Auswählens am Ende der Fertigung der Sendevorrichtung durchgeführt werden und in einem nichtflüchtigen Speicher gespeichert wird, welcher der Sender initial für einen Kommunikationsbetrieb zu verwenden ist und in welcher Reihenfolge weitere der Sender als Ersatzsender bereitstehen.

7. Verfahren nach mindestens einem der vorangehenden Ansprüche, **dadurch gekennzeichnet, dass** als Parameter zu jedem Sender (21, 22, 23) die Lichtleistung erfasst wird.

8. Verfahren nach Anspruch 7, **dadurch gekennzeichnet, dass** die Sendevorrichtung (2) des weiteren mindestens einen Lichtdetektor (24) aufweist und die Lichtleistung der Sender (21, 22, 23) mittels des mindestens einen Lichtdetektors (24) erfasst wird.

9. Verfahren nach Anspruch 8, **dadurch gekennzeichnet, dass** die Sender (21, 22, 23) zur Erfassung der Lichtleistung sequentiell angesteuert werden und der Lichtdetektor (24) einen Teil des emittierten Lichts des jeweils angesteuerten Senders (21, 22, 23) erfasst.

10. Verfahren nach mindestens einem der vorangehenden Ansprüche, **dadurch gekennzeichnet, dass** für einen Sender, bei dem der ermittelte Parameterwert mehr als einen vorgegebenen Toleranzwert von einem idealen Wert abweicht, ein Sperrflag gesetzt wird, das den entsprechenden Sender für einen Kommunikationsbetrieb sperrt.

11. Verfahren nach mindestens einem der vorangehenden Ansprüche, **dadurch gekennzeichnet, dass** die Sender (21, 22, 23) Laser sind.

12. Verfahren nach mindestens einem der vorangehenden Ansprüche, **dadurch gekennzeichnet, dass** die Sendevorrichtung (2) einen monolithischen Chip (20) aufweist, auf dem eine Mehrzahl von unabhängig ansteuerbaren Laserdioden (21, 22, 23) realisiert sind.

13. Verfahren nach Anspruch 2, **dadurch gekennzeichnet, dass** zum Feststellen eines Abweichens des aktuell für den Kommunikationsbetrieb verwendeten Senders von einem vorgegebenen Kriterium der Sender fortlaufend hinsichtlich mindestens eines Parameters überwacht wird.

14. Verfahren nach mindestens einem der vorangehenden Ansprüche, **dadurch gekennzeichnet, dass** derjenige Sender für den Kommunikationsbetrieb ausgewählt wird, dessen erfasster Parameterwert ein vorgegebenes Kriterium am besten erfüllt.

15. Vorrichtung (1) zum Betreiben einer optischen Sendevorrichtung (2), die eine Mehrzahl von unabhängig ansteuerbaren optischen Sendern (21, 22, 23) aufweist, mit
- einem Ausgangstreiber (11) zum Ansteuern der optischen Sender (21, 22, 23) unabhängig voneinander,
- einem Komparator (12) der Parameterwerte miteinander und/oder mit einem Referenzwert vergleicht, die zu mindestens einem Parameter der Sender von jedem Sender aktuell erfasst sind, und
- einer mit dem Komparator (12) verbundenen Steuervorrichtung (13), die auf der Grundlage des durch den Komparator (12) durchgeführten Vergleichs Steuerbefehle an den Ausgangstreiber (11) gibt, einen bestimmten der Mehrzahl der Sender (21, 22, 23) zu betreiben, wobei die Vorrichtung **gekennzeichnet ist durch**
- Mittel, die ein Abweichen des aktuell für den Kommunikationsbetrieb verwendeten Senders von einem - vorgegebenen Kriterium erkennen, und für diesen Fall einen anderen der Mehrzahl der Sender (21, 22, 23) für den Kommunikationsbetrieb auswählen und ein Steuersignal an den Ausgangstreiber (11) senden, den ausgewählten Sender zu betreiben, wobei
- die Mittel Steuersignale an den Ausgangstreiber (11) senden, die Lichtleistung des bisher für den Kommuniktionsbetrieb verwendeten Senders während einer Übergangszeit bis auf Null zu reduzieren und die Lichtleistung des ausgewählten Senders während der Übergangszeit auf einen maximalen Wert zu erhöhen.

16. Vorrichtung nach Anspruch 15, **gekennzeichnet durch** einen mit der Steuervorrichtung (13) verbundenen Speicher (14), in dem die ermittelten Parameterwerte oder davon abgeleitete Werte gespeichert sind.

17. Vorrichtung nach Anspruch 16, **dadurch gekennzeichnet, dass** die Mittel anhand der im Speicher (14) gespeicherten Werteden anderen der Mehrzahl der Sender (21, 22, 23) für den Kommunikationsbetrieb auswählen.

18. Vorrichtung nach mindestens einem der Ansprüche 15 bis 17, **dadurch gekennzeichnet, dass** die Steuervorrichtung (13) Mittel aufweist, die bei jedem Startvorgang der Sendevorrichtung (2) Steuersignale an den Ausgangstreiber (11) senden, die Sender (21, 22, 23) sequentiell anzusteuern

19. Vorrichtung nach Anspruch 16, **dadurch gekennzeichnet, dass** der Speicher (14) bei jedem Startvorgang der Vorrichtung (2) mit aktuellen Parameterwerten oder davon abgeleiteten Werten aktualisiert wird.

20. Vorrichtung nach mindestens einem der Ansprüche 15 bis 19, **dadurch gekennzeichnet, dass** der Komparator (12) mit mindestens einem Lichtdetektor (24) elektrisch verbunden ist, der die Lichtleistung der Sender (21, 22, 23) erfasst.

## Claims

1. Method for operating an optical transmitting device (2) comprising a plurality of independently controllable optical transmitters (21, 22, 23), with the steps:
- detecting to at least one parameter the parameter values of the individual transmitters (21, 22, 23);
- comparing the parameter values determined of each transmitter with one another and/or with a predetermined comparison value,
- selecting one of the transmitters (21, 22, 23) for the communications operation of the transmitting device (1) on the basis of the comparison,
- operating the transmitting device (2) with the selected transmitter, **characterized in that**
- upon deviation of the transmitter currently used for the communications operation from a predetermined criterion, a substitute transmitter is selected from the plurality of transmitters (21, 22, 23),
- a change of the transmitter used for the communications operation takes place **in that** the previously used transmitter is reduced in its light output and the substitute transmitter is simultaneously increased in its light output, wherein during a transition time both transmitters emit light.

2. Method according to Claim 1, **characterized by** the further steps:
- storing of the detected parameter values or values derived thereof in a memory (14),
- selecting of the substitute transmitter on the basis of the stored values, and
- using the newly selected transmitter for the further communications operation.

3. Method according to at least one of the preceding claims, **characterized in that** the steps of detecting, comparing and selecting are performed in a starting phase of the transmitting device (2).

4. Method according to Claim 3, **characterized in that** the steps of detecting, comparing and selecting are carried out in every starting phase of the transmitting device (2).

5. Method according to the Claims 2 and 4, **characterized in that** with each starting phase the parameter values stored in the memory (14) are overwritten by the parameter values currently detected anew during the starting phase.

6. Method according to at least one of the Claims 1 or 2, **characterized in that** the steps of detecting, comparing and selecting are performed at the end of the manufacture of the transmitting device, and the transmitter which ought to be used initially for communications operation and the sequence in which further ones of the transmitters are available as substitute transmitter is stored in a non-volatile memory.

7. Method according to at least one of the preceding claims, **characterized in that** as parameter to each transmitter (21, 22, 23) the light output is sensed.

8. Method according to Claim 7, **characterized in that** the transmitting device (2) in addition comprises at least one light detector (24) and the light output of the transmitters (21, 22, 23) is sensed by means of the at least one light detector (24).

9. Method according to Claim 8, **characterized in that** the transmitters (21, 22, 23) are sequentially controlled to detect the light output and the light detector (24) detects a portion of the emitted light of the transmitter (21, 22, 23) controlled in each case.

10. Method according to at least one of the preceding claims, **characterized in that** for a transmitter, with which the determined parameter value deviates from an ideal value by more than a predetermined tolerance value, a stop flag is set which stops the respective transmitter for a communications operation.

11. Method according to at least one of the preceding claims, **characterized in that** the transmitters (21, 22, 23) are lasers.

12. Method according to at least one of the preceding claims, **characterized in that** the transmitting device (2) comprises a monolithic chip (20) on which a plurality of independently controllable laser diodes (21, 22, 23) are realized.

13. Method according to Claim 2, **characterized in that** for determining a deviating of the transmitter currently used for the communications operation from a predetermined criterion the transmitter is continuously monitored with respect to at least one parameter.

14. Method according to at least one of the preceding claims, **characterized in that** the transmitter whose detected parameter value best fulfils a predetermined criterion is selected for the communications operation.

15. A device (1) for operating an optical transmitting device (2) comprising a plurality of independently controllable optical transmitters (21, 22, 23), with
- an output driver (11) for controlling the optical transmitters (21, 22, 23) independently of one another,
- a comparator (12), which compares the parameter values with one another and/or with a reference value which to at least one parameter of the transmitters are currently detected of each transmitter, and
- a control device (13) connected with the comparator (12), which control device based on the comparison conducted by the comparator (12) issues control commands to the output driver (11) to operate a specific one of the plurality of the transmitters (21, 22, 23), wherein the device is **characterized by**
- means which recognize a deviating of the transmitter currently used for the communications operation from a predetermined criterion and for this case select another one of the plurality of transmitters (21, 22, 23) for the communications operation and send a control signal to the output driver (11) to operate the selected transmitter, wherein
- the means send control signals to the output driver (11) which reduce to zero the light output of the transmitter previously used for the communications operation during a transition time and which increase the light output of the selected transmitter to a maximum value during the transition time.

16. Device according to Claim 15, **characterized by** a memory (14) connected with the control device (13) in which the determined parameter values or values derived from these are stored.

17. Device according to Claim 16, **characterized in that** the means, based on the values stored in the memory (14), select the other one of the plurality of transmitters (21, 22, 23) for the communications operation.

18. Device according to at least one of the Claims 15 to 17, **characterized in that** the control device (13) comprises means which upon each starting process of the transmitting device (2) send control signals to the output driver (11) to sequentially control the transmitters (21, 22, 23).

19. Device according to Claim 16, **characterized in that** the memory (14) upon every starting process of the device (2) is updated with current parameter values or values derived from these.

20. Device according to at least one of the Claims 15 to 19, **characterized in that** the comparator (12) is electrically connected with at least one light detector (24) which detects the light output of the transmitters (21, 22, 23).

## Revendications

1. Procédé pour utiliser un dispositif (2) d'émission optique présentant une pluralité d'émetteurs optiques (21, 22, 23) dirigeables indépendamment, avec les étapes consistant à :
- détecter, pour au moins un paramètre, les valeurs de paramètre des différents émetteurs (21, 22, 23),
- comparer les valeurs de paramètre déterminées de chaque émetteur entre elles et/ou à une valeur comparative donnée,
- sélectionner un émetteur (21, 22, 23) pour l'opération de communication du dispositif (1) d'émission au moyen de la comparaison,
- utiliser le dispositif (2) d'émission avec l'émetteur sélectionné, **caractérisé en ce que**
- lorsque l'émetteur actuellement employé pour l'opération de communication diverge par rapport à critère donné, un émetteur de rechange est sélectionné parmi la pluralité des émetteurs (21, 22, 23),
- un changement de l'émetteur utilisé pour l'opération de communication intervient du fait que l'émetteur utilisé jusqu'ici a son flux lumineux qui diminue et en même temps, l'émetteur de rechange a son flux lumineux qui augmente, de sorte que les deux émetteurs émettent de la lumière pendant une période transitoire.

2. Procédé selon la revendication 1, **caractérisé par** les étapes consécutives :
- sauvegarde des valeurs de paramètre détectées ou des valeurs déduites de celles-ci dans une mémoire (14),
- sélection de l'émetteur de rechange au moyen des valeurs sauvegardées, et
- utilisation de l'émetteur nouvellement sélectionné pour l'opération de communication consécutive.

3. Procédé selon au moins l'une des revendications précédentes, **caractérisé en ce que** les étapes de détection, de comparaison et de sélection sont réalisées pendant une phase de démarrage du dispositif (2) d'émission.

4. Procédé selon la revendication 3, **caractérisé en ce que** les étapes de détection, de comparaison et de sélection sont réalisées pendant chaque phase de démarrage du dispositif (2) d'émission.

5. Procédé selon les revendications 2 et 4, **caractérisé en ce** lors de chaque phase de démarrage, les valeurs de paramètre sauvegardées dans la mémoire (14) sont écrasées par les nouvelles valeurs de paramètre actuellement détectées lors de la phase de démarrage.

6. Procédé selon au moins l'une des revendications 1 ou 2, **caractérisé en ce que** les étapes de détection, de comparaison et de sélection sont réalisées à la fin de la production du dispositif d'émission et **en ce qu'**il est sauvegardé dans une mémoire non volatile lequel des émetteurs doit être initialement utilisé pour l'opération de communication et dans quel ordre de succession d'autres des émetteurs sont disponibles en tant qu'émetteurs de rechange.

7. Procédé selon l'une des revendications précédentes, **caractérisé en ce que** le flux lumineux est détecté en tant que paramètre pour chaque émetteur (21, 22, 23).

8. Procédé selon la revendication 7, **caractérisé en ce que** le dispositif (2) d'émission présente en outre au moins un détecteur (24) de lumière et **en ce que** le flux lumineux des émetteurs (21, 22, 23) est détecté au moyen de l'au moins un détecteur (24) de lumière.

9. Procédé selon la revendication 8, **caractérisé en ce que** les émetteurs (21, 22, 23) sont dirigés séquentiellement pour détecter le flux lumineux et **en ce que** le détecteur (24) détecte une partie de la lumière émise de l'émetteur (21, 22, 23) respectivement dirigé.

10. Procédé selon au moins l'une des revendications précédentes, **caractérisé en ce que**, pour un émetteur dont la valeur de paramètre déterminée diverge de plus d'une valeur de tolérance donnée par rapport à valeur idéale, un drapeau de blocage est déployé, lequel bloque l'émetteur correspondant pour une opération de communication.

11. Procédé selon au moins l'une des revendications précédentes, **caractérisé en ce que** les émetteurs (21, 22, 23) sont des lasers.

12. Procédé selon au moins l'une des revendications précédentes, **caractérisé en ce que** le dispositif (2) d'émission présente une puce monolithique (20), sur laquelle une pluralité de diodes laser (21, 22, 23) indépendamment dirigeables est réalisée.

13. Procédé selon la revendication 2, **caractérisé en ce que** pour constater une divergence de l'émetteur actuellement utilisé pour l'opération de communication par rapport à un critère donné, l'émetteur est continuellement surveillé au niveau d'au moins un paramètre.

14. Procédé selon au moins l'une des revendications précédentes, **caractérisé en ce que** l'émetteur sélectionné pour l'opération de communication est celui dont la valeur de paramètre détectée remplit au mieux un critère donné.

15. Dispositif (1) pour utiliser un dispositif (2) d'émission optique présentant une pluralité d'émetteurs optiques (21, 22, 23) indépendamment dirigeables, avec
- un excitateur (11) de départ pour diriger les émetteurs optiques (21, 22, 23) indépendamment l'un de l'autre,
- un comparateur (12), qui compare des valeurs de paramètre entre elles et/ou à une valeur de référence, lesquelles sont, pour au moins un paramètre des émetteurs, actuellement détectées par chaque émetteur, et
- un dispositif (13) de commande relié au comparateur (12) qui, sur la base de la comparaison effectuée par le comparateur (12), donne à l'excitateur (11) de départ des instructions de contrôle en vue d'utiliser l'un certain de la pluralité des émetteurs (21, 22, 23), le dispositif étant **caractérisé par**
- des moyens, qui décèlent une divergence de l'émetteur présentement utilisé pour l'opération de communication par rapport à un critère donné et qui, pour ce cas, sélectionnent un autre de la pluralité des émetteurs (21, 22, 23) pour l'opération de communication et envoie un signal de commande à l'excitateur (11) de départ en vue d'utiliser l'émetteur sélectionné, suite à quoi
- les moyens envoient des signaux de commande à l'excitateur (11) de départ en vue de diminuer le flux lumineux de l'émetteur utilisé jusqu'ici pour l'opération de communication jusqu'à zéro pendant une période de transition et d'augmenter le flux lumineux de l'émetteur sélectionné à une valeur maximale pendant la période de transition.

16. Dispositif selon la revendication 15, **caractérisé par** une mémoire (14) reliée au dispositif (13) de commande, dans laquelle les valeurs de paramètre déterminées ou les valeurs déduites de celles-ci sont sauvegardées.

17. Dispositif selon la revendication 16, **caractérisé en ce que** les moyens sélectionnent, à l'aide des valeurs sauvegardées dans la mémoire (14), l'autre de la pluralité des émetteurs (21, 22, 23) pour l'opération de communication.

18. Dispositif selon au moins l'une des revendications 15 à 17, **caractérisé en ce que** le dispositif (13) de commande présente des moyens qui, lors de chaque processus de démarrage du dispositif d'émission, envoie des signaux de commande à l'excitateur (11) de départ en vue de diriger séquentiellement les émetteurs (21, 22, 23).

19. Dispositif selon la revendication 16, **caractérisé en ce que** la mémoire (14) est, lors de chaque processus de démarrage du dispositif (2), actualisée avec des valeurs de paramètre actuelles ou des valeurs déduites de celles-ci.

20. Dispositif selon au moins l'une des revendications 15 à 19, **caractérisé en ce que** le comparateur (12) est électriquement relié à au moins un détecteur (24) de lumière qui détecte le flux lumineux des émetteurs (21, 22, 23).
